# EUROPÄISCHE PATENTSCHRIFT

(11) **EP 0 710 365 B1**
(45) Veröffentlichungstag und Bekanntmachung des Hinweises auf die Patenterteilung: **22.09.1999**
(21) Anmeldenummer: 94921581.8
(22) Anmeldetag: 19.07.1994
(51) Int. Cl.: G01T 7/00

(54) **VERFAHREN ZUM HERSTELLEN EINES GEKAPSELTEN DETEKTORS**
PROCESS FOR PRODUCING AN ENCAPSULATED DETECTOR
PROCEDE DE PRODUCTION D'UN DETECTEUR ENCAPSULE

(30) Priorität: 23.07.1993 DE 4324710
(43) Veröffentlichungstag der Anmeldung: 08.05.1996
(73) Patentinhaber: EURISYS MESURES, F-67834 Tanneries Cédex (FR); UNIVERSITÄT ZU KÖLN, D-50923 Köln (DE); FORSCHUNGSZENTRUM JÜLICH GMBH, 52425 Jülich (DE)
(72) Erfinder: BERST, Marc, F-67300 Schiltigheim (FR); EBERTH, Jürgen, D-51107 Köln (DE); JÄGER, Herbert, M., D-52076 Aachen (DE); KÄMMERLING, Hans, D-52249 Eschweiler (DE); LIEDER, Rainer, M., D-52428 Jülich (DE); RENFTLE, Walter, D-52353 Düren (DE)
(74) Vertreter: Metz, Siegfried
(86) Internationale Anmeldenummer: DE9400846
(87) Internationale Veröffentlichungsnummer: WO9503556

(56) Entgegenhaltungen:
- US-A- 3 055 101
- NUCLEAR INSTRUMENTS AND METHODS, Bd.69, 1969, AMSTERDAM,NL Seiten MIT 293 - 302 BUKER,H 'ein hochauflosendes gammaspektrometer mit einem bohrloch-germanium-detektor'
- PATENT ABSTRACTS OF JAPAN Bd. 17, Nr. 522 (P-1616) 20 September 1993 & JP,A,05 142 037 (FUJITSU LTD.) 08 Juni 1993

## Beschreibung

Die Erfindung bezieht sich auf ein Verfahren zum Herstellen eines gekapselten Detektors, der im Ultrahochvakuum (UHV) arbeitet und als Gamma (γ)-spektrometer geeignet ist, insbesondere eines gekapselten Germanium(Ge)-detektors. Der Detektorraum, der von einer Kapselhülle gebildet ist, wird nach Einbringen des Detektors in den Detektorraum mittels eines Kapseldeckels verschlossen. Gegenstand der Erfindung ist auch eine Kapsel für einen in UHV arbeitenden Detektor.

Zur Spektroskopie von γ-Strahlung werden heute in vielen Bereichen der Forschung und der Industrie Detektoren aus hochreinem Germanium (HPGe) eingesetzt. Diese Detektoren zeichnen sich durch sehr gute Energieauflösung und große Nachweiswahrscheinlichkeit aus - Eigenschaften, die eine universelle Verwendung in der kernphysikalischen Grundlagenforschung und der Weltraumforschung, aber auch bei der Umweltüberwachung, im Strahlenschutz, bei der zerstörungsfreien Material-analsye und in der industriellen Fertigungskontrolle ermöglichen.

Aus der Druckschrift ,,H. Büker, Ein hochauflösendes Gammaspektrometer mit einem Bohrloch-Germanium-Detektor, Nuclear Instruments and Methods, 69 (1969) 293-302" ist ein gekapselter Bohrlochdetektor bekannt, bei dem die Kapselung des Detektors aus einem Edelstahlgehäuse besteht. Der Deckel dieses Gehäuses ist mit vier Schrauben befestigt, wobei sich zwischen dem Deckel und dem Detektorgehäuse eine Indiumdichtung befindet.

Zur Messung müssen Ge-Detektoren mit flüssigem Stickstoff auf ca. -190 °C abgekühlt werden. Dazu werden die Detektoren in einen Vakuumkryostaten eingebaut, der gleichzeitig die sehr empfindliche Oberfläche der Detektoren schützt. Die derzeitige Kryostatentechnologie erschwert die Handhabung und die Wartung der Detektoren und behindert den Einsatz derselben Detektoren bei sehr verschiedenen Meßaufgaben.

So werden gekapselte Detektoren als γ-Spektrometer beispielsweise eingesetzt, um in Schwerionenreaktionen erzeugte schnellfliegende Atomkerne zu spektroskopieren. Um bei dabei auftretenden Dopplereffekten eine energetische Verbreitung der γ-Linien in Grenzen zu halten, wird angestrebt, den Raumwinkel für die Detektoren möglichst klein zu wählen, die Detektoren sollen eine hohe Granularität aufweisen. Bei der Wechselwirkung zwischen γ-Strahlen und Detektormaterie treten neben dem zu detektierenden Photoeffekt auch Streueffekte auf, insbesondere die sogenannte Comptonstreuung, die einen kontinuierlichen Strahlungsuntergrund ergeben und das Auflösungsvermögen des Detektors beeinträchtigen. Zur Minimalisierung dieses Compton-Untergrundes wird es angestrebt, den Detektor möglichst großvolumig auszubilden. Es wird darüber hinaus ein Anti-Compton-Detektor eingesetzt, mit dem die aus dem Detektor durch Streuung austretende γ-Strahlung ermittelt und unterdrückt werden kann.

Durch Einsetzen der Detektoren in evakuierte Kapseln läßt sich eine hohe Zuverlässigkeit für die mit den Detektoren erreichbaren Meßergebnisse erreichen. Die hochempfindlichen Oberflächen der Detektorkristalle werden im ultrahochvakuumdichten Raum geschützt. So ergibt sich eine leichte Handhabbarkeit der Detektoren, insbesondere bei einer Regeneration nach Strahlenschäden. Gekapselte Detektoren lassen sich vorteilhaft auch zu Clustern anordnen, die mehrere Detektoren umfassen und so durch Addition der in den einzelnen Detektoren abgegebenen Energien die Gesamtenergie eines γ-Quants mit hoher Genauigkeit trotz Comptonstreuung bestimmen lassen.

Um insbesondere für die Anordnung in Clustern eine kompakte Bauweise zu erreichen, müssen die Kapseln die Detektorkristalle möglichst eng umgeben. Zum vakuumdichten Verschließen der Kapseln nach Einbringen der Detektoren ist dafür Sorge zu tragen, daß beim Verschließen die Qualität der Detektoren erhalten bleibt und der Verschluß derart beschaffen ist, daß der Detektorraum über lange Betriebszeiten hinweg ultrahochvakuumdicht gehalten wird.

Aufgabe der Erfindung ist es somit, ein Verfahren zum Herstellen einer Kapsel für einen im UHV arbeitenden Detektor zu schaffen, wobei die Qualität des einzuschließenden Detektors trotz einer den Detektor möglichst eng umgebenden Kapselhülse nicht beeinträchtigt wird.

Diese Aufgabe wird bei einem Verfahren der eingangs genannten Art durch die im Patentanspruch 1 angegebenen Maßnahmen gelöst. Es werden Kapselhülse und -deckel unter Vakuum miteinander elektronenstrahlverschweißt, wobei der Detektor vor thermischer Belastung, insbesondere vor Erhitzung durch Wärmeleitung und Wärmestrahlung geschützt wird. Zur Qualitätssicherung insbesondere der Oberflächen der Detektorkristalle werden darüber hinaus die während des Elektronenstrahlschweißens entstehenden Dämpfe außerhalb des Detektorraums niedergeschlagen. Eine Verschmutzung der Detektoroberflächen durch Schweißdämpfe ist somit vermieden.

Bevorzugt werden die Schweißdämpfe in einer vom Detektorraum räumlich abgetrennten Kammer niedergeschlagen, Patentanspruch 2.

Eine für das Durchführen des erfindungsgemäßen Verfahrens geeignete Kapsel für einen im UHV arbeitenden Detektor, insbesondere für einen Ge-Detektor als γ-Spektrometer, weist eine den Detektorraum umgebende Kapselhülse und einen Kapseldeckel auf, mit dem der Detektorraum nach Einbringen des Detektors zu verschließen ist. Gemäß Patentanspruch 3 ist zum unter Vakuum durchzuführenden Elektronenstrahlverschweißen eine Schweißnaht zwischen Kapseldeckel und -hülse derart angeordnet, daß der Detektor während des Schweißens vor thermischer Belastung geschützt ist. Darüber hinaus ist in der Kapsel zumindest eine vom Detektorraum abgetrennte Kammer vorgesehen, in der gegebenenfalls während des Schweißens von der Schweißnaht zum Detektorraum ziehende Schweißdämpfe noch vor Erreichen des Detektorraums niedergeschlagen werden können.

Zum Elektronenstrahlverschweißen unter Vakuum weist die Kapsel eine Druckausgleichsöffnung auf, so daß der Detektorraum zur während des Schweißens evakuierten Kapselumgebung hin geöffnet ist, Patentanspruch 4. Als Druckausgleichsöffnung dient nach Patentanspruch 5 vorteilhaft ein Rohranschluß, der zum Evakuieren des Detektorraums nach dessen Verschweißung vorgesehen ist und der sich nach Erreichen des gewünschten Hochvakuums im Detektorraum durch Verformen und Abquetschen des Rohres vakuumdicht kaltverschweißen läßt.

Zum Verschweißen des Kapseldeckels mit der Kapselhülse weist der Kapseldeckel eine beim Einsetzen des Kapseldeckels in die Kapselhülse nach außen gerichtete Schweißlippe auf, die mit dem äußeren Rand der Kapselhülse die Schweißnaht bildet, Patentanspruch 6. Die Schweißlippe ist so bemessen, daß beim Elektronenstrahlschweißen mit Sicherheit ein hochvakuumdichter Verschluß zu erreichen ist.

In vorteilhafter Weise ist nach Patentansprüchen 7 bis 10 der Kapseldeckel so ausgebildet, daß beim Einsetzen des Kapseldeckels in die Kapselhülse zwischen Kapseldeckel und Kapselhülse ein Freiraum verbleibt, durch den die Kammer zum Niederschlagen der Schweißdämpfe geformt wird. Bevorzugt weist der Kapseldeckel zur Ausbildung der Kammer eine Ringnut auf, die während des Elektronenstrahlschweißens evakuierbar ist. Die Kammer enthält zum Niederschlagen der Dämpfe keine besonderen Kondensateinsätze, vielmehr ist hierzu zumindest ein Teil der Kammerwände geeignet. Zur Aufnahme der Niederschläge in besonderen Fällen lassen sich die Kammerwände zum Dampfniederschlag kühlen.

Zur Halterung des Detektors im Detektorraum dient gemäß Patentanspruch 11 ein federnd gelagerter Druckring, dessen Zylinderlänge den erforderlichen Abstand zwischen Kapseldeckel und Detektor schafft, so daß eine unzulässige Erhitzung des Detektors beim Elektronenstrahlschweißen vermieden wird.

Um ein Eindringen von Schweißdämpfen in die Detektorkammer zu vermeiden, ist zwischen Kammer und Detektorraum eine die Kammer vom Detektorraum trennende Dampfsperre angeordnet, Patentanspruch 12. Es ist nach patentanspruch 13 vorgesehen, den Kapseldeckel in die kapselhülse mittels einer Preßpassung einzusetzen, die einen festen Sitz des Kapseldeckels in der Kapselhülse während des Elektronenstrahlverschweißens garantiert und ein Übertreten von Schweißdampf in den Detektorraum verhindert. Bevorzugt weist der Kapseldeckel hierzu einen konisch geformten Rand auf.

Die Erfindung und weitere Ausgestaltungen der Erfindung werden im folgenden anhand eines Ausführungsbeispiels näher erläutert. Die Zeichnung zeigt im einzelnen:
Fig. 1 Längsschnitt durch eine Kapsel mit Detektor;
Fig. 2 Einzelheit X einer Kapsel nach Fig. 1.

Die Zeichnung zeigt eine Kapsel aus einer Aluminiumlegierung mit Kapselhülse 1 (Kapselteile 1a, 1b) und Kapseldeckel 2. Die Kapselhülse 1 umschließt einen Detektorraum 3, der zwei Detektorraumbereiche 3a, 3b aufweist. Im Bereich 3a im unteren Teil la der Kapselhülse 1 ist als γ-Spektrometer ein Detektor 4, im Ausführungsbeispiel ein Detektorkristall aus Germanium (Ge) eingesetzt. Als Detektormaterial für die γ-Spektroskopie eignet sich neben Ge auch Silicium (Si). Aus beiden Materialien lassen sich Detektoren mit hoher Energieauflösung fertigen.

Der Detektor 4 ist im Detektorraumbereich 3a mittels einer Tellerfeder 5 kraftschlüssig verspannt. Die Tellerfeder 5 wird in einer Ausnehmung eines Zentrierringes 6 zentrisch zur Achse 7 der Kapselhülse 1 geführt, der Zentrierring 6 liegt stirnseitig auf dem Detektor 4 auf.

Die Tellerfeder 5 stützt sich über eine Keramikscheibe 8 und einen Druckring 9 gegen den Kapseldeckel 2 ab. Der Druckring 9 weist hierzu eine Stützfläche 10 auf, deren Rand so bemessen ist, daß der Druckring 9 beim Einsetzen in die Kapselhülse 1 zugleich zentriert wird. Die Zylinderlänge des Druckrings 9 bestimmt im Detektorraumbereich 3b zwischen Kapseldeckel 2 und Druckringboden 11 einen Zwischenraum, der beim Elektronenstrahlverschweißen zwischen Kapselhülse und Kapseldeckel als thermischer Schutz für den im unteren Teil la der Kapselhülse untergebrachten Detektor 4 wirkt.

In der Zeichnung sind im Kapseldeckel 2 schematisch Durchführungen 12, 13 für die Meß- und Stromleitungen wiedergegeben. Eine der Durchführungen, im Ausführungsbeispiel die Durchführung 13 dient als Stromdurchführung für ein Getterelement 14, über das das erforderliche Hochvakuum im Detektorraum durch Bindung von Gasresten im Getter aufrechterhalten wird.

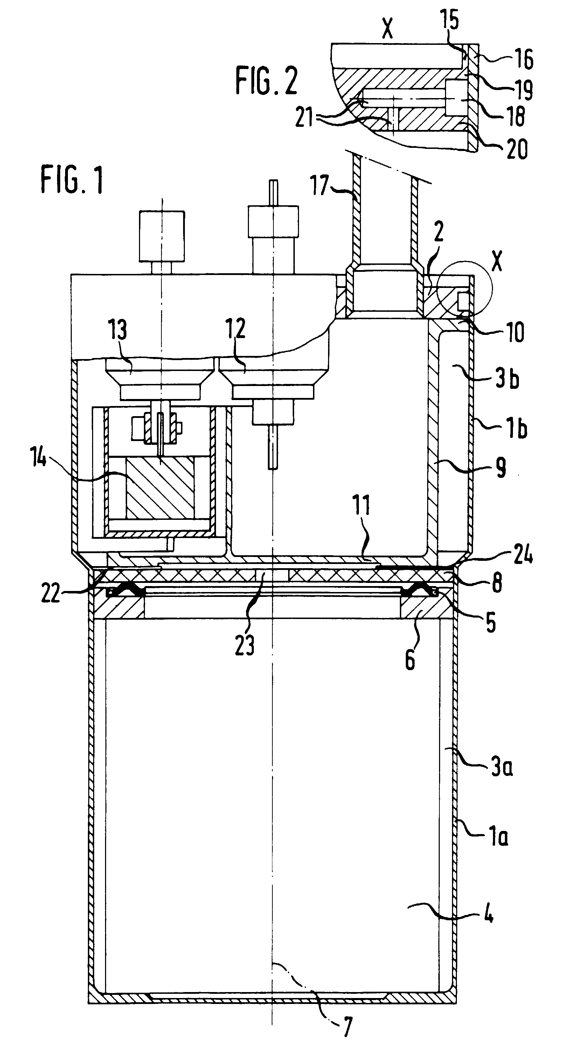

Der den Detektorraum 3a, 3b verschließende Kapseldeckel 2 weist eine nach dem Einsetzen des Kapseldeckels in die Kapselhülse 1 nach außen gerichtete Schweißlippe 15 auf, die am oberen Teil 1b der Kapselhülse am äußeren Rand 16 verschweißt wird, siehe Einzelheit X (Fig. 2). Die Stärke der Schweißlippe 15 ist gleich stark oder wenig schwächer bemessen als die Stärke des Randes 16 des oberen Kapselhülsenteils 1b, um beim Elektronenstrahlschweißen einen sicheren Hochvakuumverschluß zwischen Kapseldeckel und Kapselhülse zu erreichen.

Das Elektronenstrahlverschweißen von Kapselhülse 1 und Kapseldeckel 2 findet unter Vakuum statt. Zum Druckaus gleich zwischen Detektorraum und Kapselumgebung währen des Elektronenstrahlschweißens ist durch den Kapseldeckel 2 hindurch als Druckausgleichsöffnung 17 ein Rohranschluß geführt, über den nach Abschluß des Schweißvorgangs zur Fortsetzung der Kapselherstellung eine Evakuierung des Detektorraums 3a, 3b erfolgt. Der Rohranschluß besteht wie die Kapsel aus Aluminium. Ist im Detektorraum ein ausreichend hohes Vakuum durch Absaugen erreicht, wird der Rohranschluß durch Quetschen kaltverschweißt und ultrahochvakuumdicht verschlossen (pinch-off-Verfahren).

Damit beim Elektronenstrahlschweißen entstehende Schweißdämpfe, die gegebenenfalls in den Detektorraum 3a, 3b eindringen könnten, noch vor Erreichen de Detektorraums zurückgehalten werden können, weist der Kapseldeckel eine als Ringnut ausgebildete Kammer 18 auf, in der sich die Schweißdämpfe niederschlagen können. Im Ausführungsbeispiel ist insbesondere die äußere Kammerwand, also die Innenwand des oberen Teils 1b der Kapselhülse 1 für das Niederschlagen der Dämpfe geeignet. Die Kapselhülse kann erforderlichenfalls beim Elektronenstrahlschweißen gekühlt werden.

Zum Elektronenstrahlschweißen wird der Kapseldeckel 2 gegen den Druck der Tellerfeder 5 mittels Preßsitz kraftschlüssig in der Kapselhülse 1 verspannt. Hierzu weist der Kapseldeckel einen konisch geformten Außenrand 19 auf, mit dem der Kapseldeckel in den oberen Teil 1b der Kapselhülse 1 gedrückt wird. Diese Ausbildung des Kapseldeckels, die beim Elektronenstrahl-schweißen zugleich als Dampfsperre 20 wirkt, ist in Fig. 2 als Einzelheit X vergrößert wiedergegeben. Durch den Preßsitz ist zugleich eine Dampfsperre 20 gegeben, beim Elektronenstrahlschweißen entstehender Dampf wird innerhalb der Kammer 18 zurückgehalten und dort niedergeschlagen, ein Eindringen in den Detektorraum ist versperrt. Nach Einsetzen des Kapseldeckels 2 wird die Schweißlippe 15 des Kapseldeckels mit dem Rand 16 der Kapselhülse 1 unter Vakuum elektronenstrahlverschweißt.

Von der als Nut ausgebildeten Kammer 18 im Kapseldeckel führen Absaugöffnungen 21, die in Fig. 2 dargestellt sind, zum Detektorraumbereich 3b. Über diese Absaugöffnungen wird die Kammer 18 während des Elektronenstrahlschweißens evakuiert. Auch während des Detektorbetriebes bleibt die Kammer 17 auf diese Weise unter Hochvakuum. Die Absaugöffnungen sind derart dimensioniert, daß Schweißdämpfe nicht in den Detektorraum abgesaugt werden.

Zum Evakuieren auch des unteren Detektorraumes 3a weisen Druckringboden 11 und Keramikscheibe 8 Durchbrüche 22, 23 auf. Die Durchbrüche 22 im Druckringboden 11 befinden sich zwischen Stegen 24, mit denen der Druckringboden 11 auf der Keramikscheibe 8 aufsitzt.

## Patentansprüche

1. Verfahren zum Herstellen eines gekapselten, im Ultrahochvakuum (UHV) arbeitenden Detektors zur Gamma(y)-Spektroskopie, insbesondere eines gekapselten Germanium(Ge)-Detektors, wobei nach Einbringen des Detektors in einen von einer Kapselhülse gebildeten Detektorraum der Detektorraum mittels eines Kapseldeckels verschlossen wird,
**dadurch gekennzeichnet**,
daß der Kapseldeckel mit der Kapselhülse unter Vakuum elektronenstrahlverschweißt wird, wobei der Detektor während des Schweißens vor thermischer Belastung geschützt wird, und während des Schweißens entstehende Dämpfe außerhalb des Detektorraums abgetrennt niedergeschlagen werden.

2. Verfahren nach Anspruch 1,
**dadurch gekennzeichnet**,
daß die Dämpfe zumindest in einer vom Detektorraum abgetrennten Kammer niedergeschlagen werden.

3. Kapsel für einen im Ultrahochvakuum (UHV) arbeitenden Detektor, insbesondere für einen als γ-Spektrometer geeigneten Germanium(Ge)-Detektor, mit einer den Detektorraum umgebenden Kapselhülse und einem die Kapselhülse nach Einbringen des Detektors verschließenden Kapseldeckel,
**dadurch gekennzeichnet**,
daß zum unter Vakuum durchzuführenden Elektronenstrahlschweißen von Kapseldeckel (2) und Kapselhülse (1) am Kapseldeckel eine Schweißlippe (15) derart angeordnet ist, daß der Detektor (4) während des Verschweißens von Schweißlippe und Kapselhülse vor thermischer Belastung geschützt ist, und daß in der Kapsel zumindest eine vom Detektorraum (3, 3a, 3b) abgetrennte Kammer (18) zum Niederschlagen von während des Schweißens entstehender Dämpfe vorgesehen ist.

4. Kapsel nach Anspruch 3,
**dadurch gekennzeichnet,**
daß der Detektorraum (3, 3a, 3b) eine zur Kapselumgebung hin offene Druckausgleichsöffnung (17) aufweist, die beim Schweißen geöffnet ist.

5. Kapsel nach Anspruch 4,
**dadurch gekennzeichnet,**
daß die Druckausgleichsöffnung (17) von einem zum Evakuieren des abgeschlossenen Detektorraums (3, 3a, 3b) nach dem Elektronenstrahlverschweißen vorgesehenen Rohranschluß gebildet wird, der nach Erreichen des vorgesehenen Vakuums im Detektorraum (3, 3a, 3b) durch Abquetschen vakuumdicht kaltveschweißbar ist.

6. Kapsel nach Anspruch 3, 4 oder 5,
**dadurch gekennzeichnet,**
daß die Schweißlippe (15) des Kapseldeckels (2) nach dem Einsetzen des Kapseldeckels (2) in die Kapselhülse (1) nach außen gerichtet ist.

7. Kapsel nach einem der Ansprüche 3 bis 6,
**dadurch gekennzeichnet,**
daß der Kapseldeckel (2) derart geformt ist, daß beim Einsetzen des Kapseldeckels (2) in die Kapselhülse (1) ein Freiraum verbleibt, der die Kammer (18) zum Niederschlagen der Schweißdämpfe bildet.

8. Kapsel nach Anspruch 7,
**dadurch gekennzeichnet,**
daß der Kapseldeckel (2) zur Ausbildung der Kammer (18) eine Ringnut aufweist, die während des Elektronenstrahlschweißens evakuierbar ist.

9. Kapsel nach einem der Ansprüche 7 oder 8,
**dadurch gekennzeichnet,**
daß zumindest ein Teil der Kammerwände der Kammer (18) zum Niederschlagen der Dämpfe geeignet ist.

10. Kapsel nach einem der Ansprüche 3 bis 9,
**dadurch gekennzeichnet,**
daß die Kammer (18) zu ihrer Evakuierung im Detektorraum (3, 3a, 3b) mündende Absaugöffnungen (21) aufweist.

11. Kapsel nach einem der Ansprüche 3 bis 10,
**dadurch gekennzeichnet,**
daß zur Halterung des Detektors (4) im Detektorraum (3, 3a, 3b) ein federnd gelagerter Druckring (9) dient.

12. Kapsel nach einem der Ansprüche 3 bis 11,
**dadurch gekennzeichnet,**
daß zwischen Kammer (18) und Detektorraumm (3, 3a, 3b) eine die Kammer vom Detektorraum trennende Dampfsperre (20) eingesetzt ist.

13. Kapsel nach Anspruch 12,
**dadurch gekennzeichnet,**
daß zum Einsetzen des Kapseldeckels (2) in die Kapselhülse (1) eine Preßpassung vorgesehen ist.

## Claims

1. Process for making an encapsulated detector operating in an ultra-high vacuum (UHV) for gamma (γ) spectroscopy, more particularly an encapsulated germanium (Ge) detector, where after the detector has been placed in a detector compartment constituted by a capsule sleeve the detector compartment is sealed by means of a capsule lid,
**characterised in that**
the capsule lid is electron-beam welded to the capsule sleeve *in vacuo,* the detector being protected from thermal stress during the welding operation, and fumes that are produced during the welding operation being precipitated at a separate location outside the detector compartment.

2. Process according to claim 1,
**characterised in that**
the fumes are precipitated in at least one chamber separated from the detector compartment.

3. Capsule for a detector operating in an ultra-high vacuum (UHV), more particularly for a germanium (GE) detector suitable for use as a γ-spectrometer, having a capsule sleeve which surrounds the detector compartment and a capsule lid which seals the capsule sleeve once the detector is placed inside,
**characterised in that**
in order to carry out the electron-beam welding of the capsule lid (2) and capsule sleeve (1) *in vacuo,* a weld lip (15) is disposed on the capsule lid in such a manner that during the welding operation the detector (4) is protected by the weld lip and the capsule sleeve from thermal stress, and that provided in the capsule is at least one chamber (18) separate from the detector compartment (3, 3a, 3b) for the precipitation of fumes produced during the welding operation.

4. Capsule according to claim 3,
**characterised in that**
the detector compartment (3, 3a, 3b) has a pressure compensating port (17) which opens towards the neighbourhood of the capsule and is open during the welding operation.

5. Capsule according to claim 4,
**characterised in that**
the pressure compensating port (17) is formed by a pipe fitting provided to evacuate the closed detector compartment (3, 3a, 3b) following the electron-beam welding operation, said pipe fitting being adapted to be hermetically cold-welded by pinching it off once the envisaged vacuum in the detector compartment (3, 3a, 3b) has been obtained.

6. Capsule according to claim 4 or 5,
**characterised in that**
once the capsule lid (2) has been inserted into the capsule sleeve (1) the weld lip (15) of the capsule lid (2) is directed outwards.

7. Capsule according to any of claims 3 to 6,
**characterised in that**
the capsule lid (2) is shaped in such a way that inserting the capsule lid (2) into the capsule sleeve (1) leaves a space which forms the chamber (18) for the precipitation of the welding fumes.

8. Capsule according to claim 7,
**characterised in that**
to construct the chamber (18) the capsule lid (2) has an annular groove which is adapted to be evacuated during the electron-beam welding operation.

9. Capsule according to either of claims 7 and 8,
**characterised in that**
at least part of the walling of the chamber (18) is suitable for precipitation of the fumes.

10. Capsule according to any of claims 3 to 9,
**characterised in that**
for its evaculation the chamber (18) has exhaust ports (21) which open out in the detector compartment (3, 3a, 3b).

11. Capsule according to any of claims 3 to 10,
**characterised in that**
a spring-mounted thrust collar (9) is used to mount the detector (4) in the detector compartment (3, 3a, 3b).

12. Capsule according to any of claims 3 to 11,
**characterised in that**
inserted between the chamber (18) and the detector compartment (3, 3a, 3b) is a vapour barrier (20) which divides the chamber from the detector compartment.

13. Capsule according to claim 12,
**characterised in that**
a driving fit is provided for inserting the capsule lid (2) into the capsule sleeve (1).

## Revendications

1. Procédé de fabrication d'un détecteur pour spectroscopie gamma (γ), encapsulé et fonctionnant sous ultravide (UHV), en particulier d'un détecteur encapsulé au germanium (Ge), l'espace de détection étant obturé à l'aide d'un couvercle de capsule après que le détecteur a été introduit dans un espace de détection formé par une enveloppe de capsule, caractérisé en ce que le couvercle de capsule est soudé par bombardement électronique sous vide à l'enveloppe de capsule, le détecteur, pendant le soudage, étant protégé des contraintes thermiques, et les vapeurs qui se forment pendant le soudage précipitant d'une manière séparée à l'extérieur de l'espace de détection.

2. Procédé selon la revendication 1, caractérisé en ce que les vapeurs précipitent au moins dans une chambre séparée de l'espace de détection.

3. Capsule pour un détecteur fonctionnant sous ultravide (UHV), en particulier pour un détecteur au germanium (Ge) pouvant être utilisé en tant que spectromètre γ, comportant une enveloppe de détecteur qui entoure l'espace de détection et un couvercle de capsule, qui obture l'enveloppe de capsule après introduction du détecteur, caractérisée en ce que, pour le soudage par bombardement électronique, qui doit être exécuté sous vide, du couvercle de capsule (2) et de l'enveloppe de capsule (1) au couvercle de capsule, une lèvre de soudage (15) est disposée de façon que le détecteur (4), pendant le soudage de la lévre de soudage et de l'enveloppe de capsule, soit protégé des contraintes thermiques, et au moins une chambre (18), séparée de l'espace de détection (3, 3a, 3b), est prévue dans la capsule pour permettre la précipitation de vapeurs qui se forment pendant le soudage.

4. Capsule selon la revendication 3, caractérisée en ce que l'espace de détection (3, 3a, 3b) comporte une ouverture (17) de compensation de pression, débouchant sur l'environnement de la capsule, qui est ouverte lors du soudage.

5. Capsule selon la revendication 4, caractérisée en ce que l'ouverture (17) de compensation de pression est formée par un raccord de tuyauterie, prévu pour faire le vide dans l'espace de détection obturé (3, 3a, 3b) après le soudage par bombardement électronique, raccord qui, après que l'on a atteint le vide prévu dans l'espace de détection (3, 3a, 3b), peut être soudé à froid par écrasement d'une manière étanche au vide.

6. Capsule selon la revendication 3, 4 ou 5, caractérisée en ce que la lèvre de soudage (15) du couvercle de capsule (2) est, après mise en place du couvercle de capsule (2) dans l'enveloppe de capsule (1), dirigée vers l'extérieur.

7. Capsule selon l'une des revendications 3 à 6, caractérisée en ce que le couvercle de capsule (2) est formé de telle sorte que, lors de la mise en place du couvercle de capsule (2) dans l'enveloppe de capsule (1), il reste un espace libre qui forme la chambre (18) assurant la précipitation des vapeurs de soudage.

8. Capsule selon la revendication 7, caractérisée en ce que le couvercle de capsule (2) comporte, pour constituer la chambre (18), une rainure annulaire dans laquelle on peut faire le vide pendant le soudage par bombardement électronique.

9. Capsule selon l'une des revendications 7 ou 8, caractérisée en ce qu'au moins une partie des parois de la chambre (18) convient à la précipitation des vapeurs.

10. Capsule selon l'une des revendications 3 à 9, caractérisée en ce que la chambre (18) comporte, pour qu'on puisse y faire le vide, des ouvertures d'aspiration (21) qui débouchent dans l'espace de détection (3, 3a, 3b).

11. Capsule selon l'une des revendications 3 à 10, caractérisée en ce qu'une bague de compression (9), à support élastique, sert à maintenir le détecteur (4) dans l'espace de détection (3, 3a, 3b).

12. Capsule selon l'une des revendications 3 à 11, caractérisée en ce qu'une barrière de vapeur (20), qui sépare la chambre de l'espace de détection, est mise en place entre la chambre (18) et l'espace de détection (3, 3a, 3b).

13. Capsule selon la revendication 12, caractérisée en ce qu'on prévoit un ajustement serré pour mettre en place le couvercle de capsule (2) dans la de capsule (1).
